# EUROPÄISCHE PATENTSCHRIFT

(11) **EP 3 500 075 B1**
(45) Veröffentlichungstag und Bekanntmachung des Hinweises auf die Patenterteilung: **20.11.2019**
(21) Anmeldenummer: 17207333.0
(22) Anmeldetag: 14.12.2017
(51) Int. Cl.: H05K 7/14, H01R 12/52, H04L 29/08

(54) **KOMMUNIKATIONSMODUL FÜR EIN KOMMUNIKATIONS- ODER AUTOMATISIERUNGSGERÄT**
COMMUNICATIONS MODULE FOR A COMMUNICATION OR AUTOMATION DEVICE
MODULE DE COMMUNICATION POUR UN APPAREIL DE COMMUNICATION OU D'AUTOMATISATION

(43) Veröffentlichungstag der Anmeldung: 19.06.2019
(73) Patentinhaber: Siemens Aktiengesellschaft, 80333 München (DE)
(72) Erfinder: SCHWEIZER, Urs, 76316 Malsch-Waldprechtsweier (DE)

(56) Entgegenhaltungen:
- EP-A1- 0 419 694
- DE-A1- 2 347 751
- US-A- 4 790 762

## Beschreibung

Die vorliegende Erfindung betrifft ein Kommunikationsmodul für ein Kommunikations- oder Automatisierungsgerät, wobei das Kommunikationsmodul ein Gehäuse umfasst, das einen in Kontakt mit einem Grundmodul des Kommunikations- oder Automatisierungsgeräts bringbaren Anschlussbereich aufweist.

Ein industrielles Automatisierungssystem umfasst üblicherweise eine Vielzahl von Kommunikations- und Automatisierungsgeräten, die über ein industrielles Kommunikationsnetz miteinander vernetzt sind und im Rahmen einer Fertigungs- oder Prozessautomatisierung zur Steuerung oder Regelung von Anlagen, Maschinen bzw. Geräten dienen. Zu Kommunikations- und Automatisierungsgeräten zählen beispielsweise speicherprogrammierbare Steuerung, dezentrale Peripheriemodule, Schütze, Kommunikationsmodule, Switches und Router. Aufgrund zeitkritischer Rahmenbedingungen in technischen Systemen, die mittels industrieller Automatisierungsgeräte automatisiert sind, werden in industriellen Kommunikationsnetzen zur Kommunikation zwischen Automatisierungsgeräten überwiegend Echzeit-Kommunikationsprotokolle, wie PROFINET, PROFIBUS oder Real-Time-Ethernet, verwendet.

Aus DE 10 2010 062065 A1 ist ein modulares Elektronikgerät bekannt, das ein elektronisches Grundgerät, ein Elektronikmodul zur elektrischen Verbindung mit dem Grundgerät und zur mechanischen Halterung am Grundgerät umfasst. Das Elektronikmodul und das Grundgerät sind derart ausgestaltet, dass das Elektronikmodul in einer Anbringstellung mechanisch mit dem Grundgerät gekoppelt werden kann. Durch eine nachfolgende Schwenkbewegung kann das Elektronikmodul in eine Zwischenstellung geschwenkt und anschließend durch eine Schubbewegung in eine Verbindungsstellung gebracht werden. In der Verbindungsstellung ist das Elektronikmodul elektrisch mit dem Grundgerät verbunden und mechanisch an diesem fixiert.

DE 692 00 539 T2 betrifft eine modulare elektronische Einheit, bei der ein elektronisches Modul mit einer Gehäusekante zunächst an einen Anschlag eines Modulträgers sowie an einem korrespondierenden Gehäuseanschlag am elektronischen Modul gekoppelt wird. Durch eine nachfolgende Schwenkbewegung wird das elektronische Modul gegen eine im Bereich des Anschlags angeordnete Klemmfeder in eine Verbindungsstellung gebracht, in der elektronisches Modul und Modulträger vorzugsweise miteinander verrastet sind.

In EP 2 456 133 B1 ist ein modularer Schalt-Netzknoten für ein industrielles Kommunikationsnetz beschrieben. Der modulare Schalt-Netzknoten umfasst eine Schalt-Netzknoten-Basiseinheit und mindestens ein Port-Modul, das mindestens eine Anschluss-Schnittstelle zur Ankopplung an das Kommunikationsnetz aufweist. Des Weiteren ist der modulare Schalt-Netzknoten zur Weiterleitung von Kommunikationsdaten, die über eine Anschluss-Schnittstellen des modularen Schalt-Netzknotens eingehen, an mindestens eine weitere Anschluss-Schnittstelle ausgestaltet. Darüber hinaus kann zur Funktionalitätserweiterung ein Port-Modul gegen ein Funktionsmodul ausgetauscht werden.

EP 2 819 494 A1 betrifft ein modulares Kommunikationsgerät für ein industrielles Automatisierungssystem mit einem Grundmodul und zumindest einem mit dem Grundmodul verbindbaren Erweiterungsmodul. Das Grundmodul und das zumindest eine Erweiterungsmodul weisen zueinander korrespondierende mehrpolige Steckverbindungselemente auf. Am Erweiterungsmodul sind Zentrierstifte vorgesehen, die jeweils in eine Aussparung an einer Verrieglungskulisse des Grundmoduls einführbar und dort verrastbar sind. Die Zentrierstifte weisen jeweils eine sich an einen konischen Kopf anschließende umlaufende Nut auf, in die jeweils ein Rastelement der Verriegelungskulisse in einem verriegelten Zustand eingreift. Die Verriegelungskulisse ist senkrecht zu den Zentrierstiften von einer Verriegelungsposition in eine Entriegelungsposition verschiebbar, in der die Rastelemente der Verriegelungskulisse die Nuten der Zentrierstifte freigeben.

Der vorliegenden Erfindung liegt die Aufgabe zugrunde, ein Kommunikationsmodul für ein Kommunikations- oder Automatisierungsgerät zu schaffen, das einfach und robust gegenüber Vibrationen und Stößen mit einem Grundmodul des Kommunikations- oder Automatisierungsgeräts verbunden werden kann.

Diese Aufgabe wird erfindungsgemäß durch ein Kommunikationsmodul für ein Kommunikations- oder Automatisierungsgerät mit den in Anspruch 1 angegebenen Merkmalen gelöst. Vorteilhafte Weiterbildungen der vorliegenden Erfindung sind in den abhängigen Ansprüchen angegeben.

Das erfindungsgemäße Kommunikationsmodul für ein Kommunikations- oder Automatisierungsgerät umfasst ein Gehäuse, das einen in Kontakt mit einem Grundmodul des Kommunikations- oder Automatisierungsgeräts bringbaren Anschlussbereich aufweist. Außerdem sind im Anschlussbereich zumindest zwei Zentrierstifte vorgesehen, die in korrespondierende Aufnahmen des Grundmoduls steckbar sind. Im Anschlussbereich können beispielsweise mehrpolige Steckverbindungselemente vorgesehen sein, die mit korrespondierenden Steckverbindungselementen am Grundmodul verbindbar sind. Das Gehäuse des Kommunikationsmoduls umfasst vorzugsweise zumindest eine Sende- und Empfangseinheit, die entsprechend einem ausgewählten Bitübertragungsschicht- bzw. Sicherungsschichtprotokoll ausgestaltet ist.

Erfindungsgemäß umfasst das Kommunikationsmodul eine das Gehäuse zwischen den Zentrierstiften mit einem Gewindeabschnitt durchdringende Befestigungsschraube. Dabei ist der Gewindeabschnitt der Befestigungsschraube in eine Gewindebohrung des Grundmoduls schraubbar. Darüber hinaus ist ein im wesentlich mittig im Gehäuse angeordneter, senkrecht zum Anschlussbereich verlaufender Durchgang zur Aufnahme der Befestigungsschraube vorgesehen. Mit der Befestigungsschraube ist ein Mitnehmerring verbunden, der einen Abschnitt eines Schafts der Befestigungsschraube umgibt. Entlang des Durchgangs ist im Gehäuse eine Aussparung für den Mitnehmerring vorgesehen, der innerhalb der Aussparung axial verschiebbar ist.

Vorteilhafterweise werden über den Mitnehmerring bei einem Verschrauben des Kommunikationsmoduls mit dem Grundmodul durch Formschluss zwischen Mitnehmerring und Gehäuse des Kommunikationsmoduls erforderliche Steckkräfte auf das Gehäuse übertragen. Bei einer Demontage wird die Befestigungsschraube in Ausschraubrichtung gedreht, so dass das Gehäuse des Kommunikationsmoduls über den Mitnehmerring vom Grundmodul wegbewegt wird. Auf diese Weise werden zur Demontage erforderliche Zugkräfte einfach realisiert, so dass das Kommunikationsmodul bequem vom Grundmodul entfernt werden kann. Durch die Zentrierstifte und die Befestigungsschraube ist zudem sichergestellt, dass das Kommunikationsmodul korrekt und sicher montiert bzw. demontiert wird. Insbesondere aufgrund von Anordnung und Ausgestaltung der Befestigungsschraube einschließlich des Mitnehmerrings kann eine kompakte Bauform des Kommunikationsmoduls realisiert werden, das nur eine geringe Anzahl mechanischer Komponenten aufweist.

Entsprechend einer vorteilhaften Weiterbildung des erfindungsgemäßen Kommunikationsmoduls weisen die Zentrierstifte jeweils einen konischen Kopf auf. Darüber hinaus können die Zentrierstifte Rastelemente umfassen, so dass sie in den korrespondierenden Aufnahmen des Grundmoduls verrastet werden können.

Vorzugsweise ist an den Mitnehmerring ein Rändelrad zum Drehen der Befestigungsschraube angeformt. Damit kann das Kommunikationsmodul auch werkzeugfrei am Grundkörper montiert werden. Der Mitnehmerring ist vorteilhafterweise drehfest mit dem Schaft der Befestigungsschraube verbunden.

Entsprechend einer weiteren Ausgestaltung der vorliegenden Erfindung bilden axiale Enden der Aussparung entlang des Durchgangs jeweils einen Anschlag für den Mitnehmerring. In einer Endposition stößt damit ein Anschlag des Kommunikationsmoduls definiert an einen Anschlag des Grundmoduls, wobei die Zentrierstifte des Kommunikationsmoduls formschlüssig in den korrespondierenden Aufnahmen des Grundmoduls stecken und eine mechanisch sichere Verbindung des Kommunikationsmoduls mit dem Grundmodul ermöglichen.

Die vorliegende Erfindung wird nachfolgend an einem Ausführungsbeispiel anhand der Zeichnung näher erläutert. Es zeigt
- Figur 1: eine perspektivische Darstellung eines Kommunikationsmoduls für ein modulares Kommunikations- oder Automatisierungsgerät,
- Figur 2: eine perspektivische Darstellung einer Befestigungsschraube des Kommunikationsmoduls gemäß Figur 1,
- Figur 3: eine Schnittdarstellung des Kommunikationsmoduls gemäß Figur 1 sowie eines Grundmoduls des modularen Kommunikations- oder Automatisierungsgeräts während einer Montage des Kommunikationsmoduls,
- Figur 5: eine Schnittdarstellung des Kommunikationsmoduls und des Grundmoduls in montiertem Zustand des Kommunikationsmoduls,

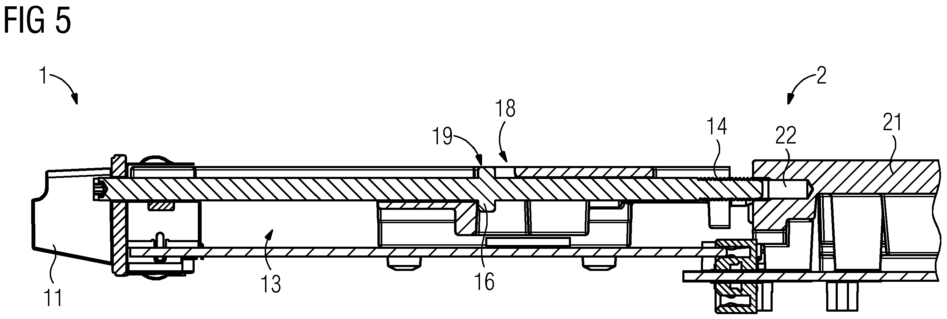

- Figur 5: eine Schnittdarstellung des Kommunikationsmoduls und des Grundmoduls während einer Demontage des Kommunikationsmoduls.

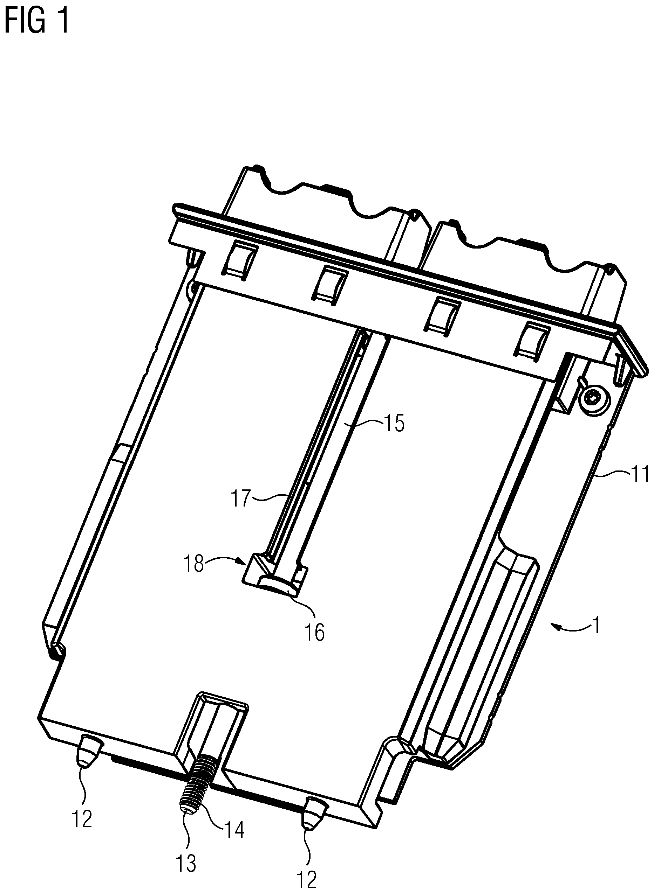

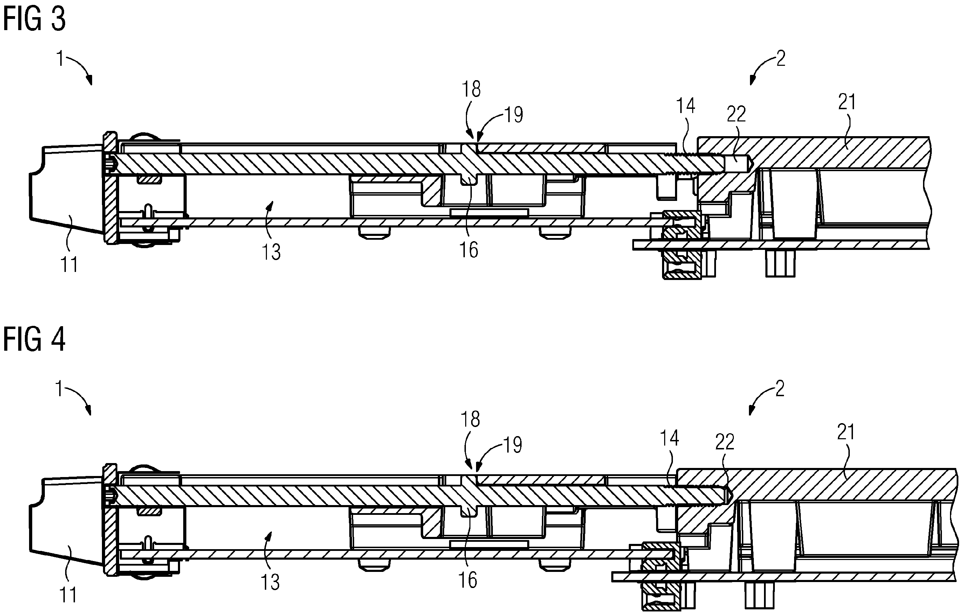

Das in Figur 1 dargestellte Kommunikationsmodul 1 für ein modulares Kommunikations- oder Automatisierungsgerät umfasst ein Gehäuse 11, das einen in Kontakt mit einem Grundmodul 2 des Kommunikations- oder Automatisierungsgeräts bringbaren Anschlussbereich aufweist (siehe auch Figur 3). Im Anschlussbereich sind mehrpolige Steckverbindungselemente vorgesehen, die mit korrespondierenden Steckverbindungselementen am Grundmodul 2 verbindbar sind. Das Kommunikations- oder Automatisierungsgerät kann beispielsweise ein Switch für ein Kommunikationsnetz eines industriellen Automatisierungssystems sein. Im vorliegenden Ausführungsbeispiel umfasst das Gehäuse 11 des Kommunikationsmoduls 1 eine Sende- und Empfangseinheit mit einem PHY- und einem MAC-Schaltkreis, die entsprechend einem ausgewählten Bitübertragungsschicht- bzw. Sicherungsschichtprotokoll ausgestaltet sind. Üblicherweise weist ein Switch mehrere Sende- und Empfangseinheiten auf, die jeweils von einem separaten Kommunikationsmodul umfasst sein können und über ein Koppelelement schaltbar miteinander verbindbar sind. Das Koppelelement kann insbesondere ein Hochgeschwindigkeitsbus oder ein Backplane Switch mit zugeordnetem Controller sein.

Im Anschlussbereich des Kommunikationsmoduls 1 sind zwei Zentrierstiften 12 vorgesehen, die in korrespondierende Aufnahmen des Grundmoduls 2 steckbar sind. Dabei weisen die Zentrierstifte 12 jeweils einen konischen Kopf auf. Grundsätzlich können die Zentrierstifte 12 auch Rastelemente umfassen und somit in den korrespondierenden Aufnahmen des Grundmoduls 2 durch Verrasten zusätzlich fixiert werden.

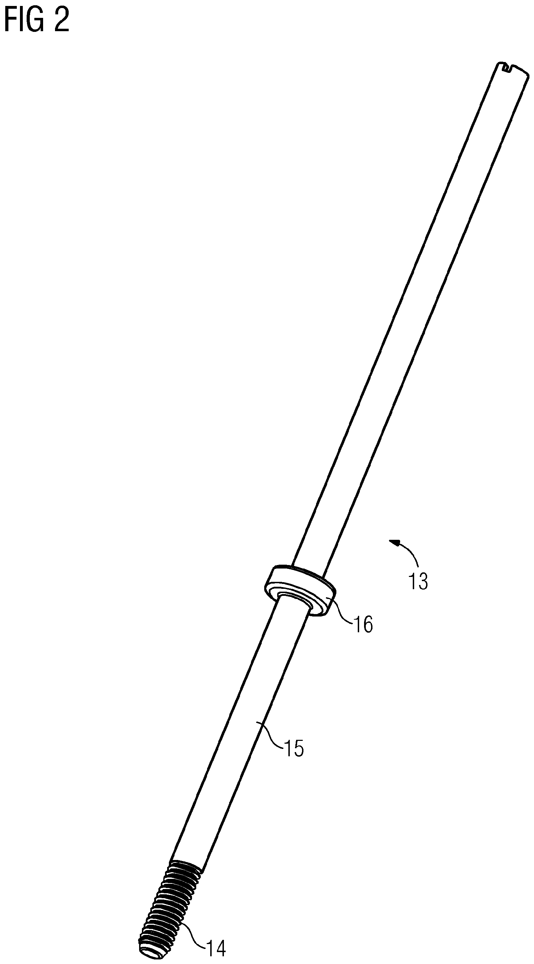

Zwischen den Zentrierstiften 12 durchdringt eine Befestigungsschraube 13 mit einem Gewindeabschnitt 14 das Gehäuse 11 des Kommunikationsmoduls 1 (sieh auch Figur 2). Entsprechend den Schnittdarstellungen in den Figuren 3-5 ist der Gewindeabschnitt 14 der Befestigungsschraube 13 in eine Gewindebohrung 22 an einem Gehäuse 21 des Grundmoduls 2 schraubbar, beispielsweise mittels eines an einem Schraubenkopf angesetzten Schraubendrehers. Durch die Zentrierstifte 12 und die Befestigungsschraube 13 wird eine korrekte und sichere Montage bzw. Demontage des Kommunikationsmoduls 1 gewährleistet.

Mittig im Gehäuse 11 des Kommunikationsmoduls ist ein Durchgang 17 zur Aufnahme der Befestigungsschraube 13 angeordnet. Dabei verläuft der Durchgang 17 senkrecht zum Anschlussbereich. Mit der Befestigungsschraube 13 ist ein Mitnehmerring 16 verbunden, der einen Abschnitt eines Schafts 15 der Befestigungsschraube 13 umgibt. Der Mitnehmerring 16 ist vorzugsweise drehfest mit dem Schaft der Befestigungsschraube 13 verbunden. Für eine werkzeuglose Montage bzw. Demontage kann an den Mitnehmerring 16 beispielsweise ein Rändelrad zum Drehen der Befestigungsschraube 13 angeformt sein.

Im Gehäuse 11 des Kommunikationsmoduls ist entlang des Durchgangs 17 eine Aussparung 18 für den Mitnehmerring 16 vorgesehen. Der Mitnehmerring 16 ist innerhalb dieser Aussparung 18 axial verschiebbar, wobei axiale Enden der Aussparung 18 entlang des Durchgangs 17 jeweils einen Anschlag 19 für den Mitnehmerring 16 bilden.

Entsprechend den Schnittdarstellungen in den Figuren 3-5 werden über den Mitnehmerring 16 bei einer Montage des Kommunikationsmoduls 1 am Grundmodul 2 durch Formschluss zwischen dem Mitnehmerring 16 und dem Gehäuse 11 des Kommunikationsmoduls 1 erforderliche Steckkräfte auf das Gehäuse 11 übertragen. In montiertem Zustand ist die Befestigungsschraube 14 mit ihrem Gewindeabschnitt 14 vollständig in die Gewindebohrung 22 am Gehäuse 21 des Grundmoduls 2 gedreht (siehe Figur 4) .

In umgekehrter Weise wird die Befestigungsschraube 13 bei einer Demontage in Ausschraubrichtung gedreht, so dass das Gehäuse 11 des Kommunikationsmoduls 1 über den Mitnehmerring 16 vom Gehäuse 21 des Grundmoduls 2 wegbewegt wird (siehe Figur 5). Danach kann das Kommunikationsmodul 1 einfach vom Grundmodul 2 abgenommen werden.

## Patentansprüche

1. Kommunikationsmodul für ein Kommunikations- oder Automatisierungsgerät mit
- einem Gehäuse (11), das einen in Kontakt mit einem Grundmodul (2) des Kommunikations- oder Automatisierungsgeräts bringbaren Anschlussbereich aufweist,
- zumindest zwei im Anschlussbereich vorgesehenen Zentrierstiften (12), die in korrespondierende Aufnahmen des Grundmoduls (2) steckbar sind,
- einer das Gehäuse (11) zwischen den Zentrierstiften (12) mit einem Gewindeabschnitt (14) durchdringenden Befestigungsschraube (13), wobei der Gewindeabschnitt der Befestigungsschraube in eine Gewindebohrung (22) des Grundmoduls (2) schraubbar ist,
- einem im wesentlich mittig im Gehäuse (11) angeordneten, senkrecht zum Anschlussbereich verlaufenden Durchgang (17) zur Aufnahme der Befestigungsschraube (13),
- einem mit der Befestigungsschraube (13) verbundenen Mitnehmerring (16), der einen Abschnitt eines Schafts (15) der Befestigungsschraube umgibt,
- einer im Gehäuse (11) entlang des Durchgangs (17) vorgesehenen Aussparung (18) für den Mitnehmerring (16), der innerhalb der Aussparung axial verschiebbar ist.

2. Kommunikationsmodul nach Anspruch 1,
bei dem im Anschlussbereich mehrpolige Steckverbindungselemente vorgesehen sind, die mit korrespondierenden Steckverbindungselementen am Grundmodul verbindbar sind.

3. Kommunikationsmodul nach einem der Ansprüche 1 oder 2,
bei dem die Zentrierstifte jeweils einen konischen Kopf aufweisen.

4. Kommunikationsmodul nach einem der Ansprüche 1 bis 3,
bei dem die Zentrierstifte Rastelemente umfassen und in den korrespondierenden Aufnahmen des Grundmoduls verrastbar sind.

5. Kommunikationsmodul nach einem der Ansprüche 1 bis 4,
bei dem an den Mitnehmerring ein Rändelrad zum Drehen der Befestigungsschraube angeformt ist.

6. Kommunikationsmodul nach einem der Ansprüche 1 bis 5,
bei dem der Mitnehmerring drehfest mit dem Schaft der Befestigungsschraube verbunden ist.

7. Kommunikationsmodul nach einem der Ansprüche 1 bis 6,
bei dem axiale Enden der Aussparung entlang des Durchgangs jeweils einen Anschlag für den Mitnehmerring bilden.

8. Kommunikationsmodul nach einem der Ansprüche 1 bis 7,
bei dem das Gehäuse zumindest eine Sende- und Empfangseinheit umfasst, die entsprechend einem ausgewählten Bitübertragungsschicht- und/oder Sicherungsschichtprotokoll ausgestaltet ist.

## Claims

1. Communication module for a communication or automation device, comprising
- a housing (11) which has a connection region which can be brought into contact with a base module (2) of the communication or automation device,
- at least two centring pins (12) which are provided in the connection region and can be inserted into corresponding receptacles of the base module (2),
- a fastening screw (13) which passes through the housing (11) between the centring pins (12) by way of a threaded section (14), wherein the threaded section of the fastening screw can be screwed into a threaded bore (22) of the base module (2),
- a passage (17), which is arranged substantially centrally in the housing (11) and runs perpendicularly in relation to the connection region, for receiving the fastening screw (13),
- a driver ring (16) which is connected to the fastening screw (13) and surrounds a section of a shaft (15) of the fastening screw,
- a cutout (18), which is provided in the housing (11) along the passage (17), for the driver ring (16) which can be axially displaced within the cutout.

2. Communication module according to Claim 1,
in which multipole plug-in connecting elements are provided in the connection region, which plug-in connecting elements can be connected to corresponding plug-in connecting elements on the base module.

3. Communication module according to either of Claims 1 and 2,
in which the centring pins each have a conical head.

4. Communication module according to one of Claims 1 to 3,
in which the centring pins comprise latching elements and can be latched into the corresponding receptacles of the base module.

5. Communication module according to one of Claims 1 to 4,
in which a knurled wheel for turning the fastening screw is integrally formed on the driver ring.

6. Communication module according to one of Claims 1 to 5,
in which the driver ring is connected in a rotationally fixed manner to the shaft of the fastening screw.

7. Communication module according to one of Claims 1 to 6,
in which axial ends of the cutout each form a stop for the driver ring along the passage.

8. Communication module according to one of Claims 1 to 7,
in which the housing comprises at least one transmitting and receiving unit which is configured in accordance with a selected physical layer and/or data link layer protocol.

## Revendications

1. Module de communication d'un appareil de communication ou d'automatisation, comprenant
- un boîtier (11), qui a une partie de connexion pouvant être mise en contact avec un module (2) de base de l'appareil de communication ou d'automatisation,
- au moins deux broches (12) de centrage, qui sont prévues dans la partie de connexion et qui peuvent être enfichées dans des logements correspondants du module (2) de base,
- une vis (13) de fixation, traversant le boîtier (11) entre les broches (12) de centrage, par une partie (14) filetée, la partie filetée de la vis de fixation pouvant être vissée dans un taraudage (22) du module (2) de base,
- un passage (17), qui est disposé sensiblement au milieu du boîtier (11), qui s'étend perpendiculairement à la partie de connexion et qui est destiné à recevoir la vis (13) de fixation,
- une bague (16) d'entraîneur, qui est reliée à la vis (13) de fixation et qui entoure une partie d'un fût (15) de la vis de fixation,
- un évidement (18), prévu dans le boîtier (11) le long du passage (17) et destiné à la bague (16) d'entraîneur, qui peut coulisser axialement à l'intérieur de l'évidement.

2. Module de communication suivant la revendication 1,
dans lequel il est prévu, dans la partie de connexion, plusieurs éléments multipolaires de liaison par enfichage, qui peuvent être reliés au module de base par des éléments correspondant de liaison par enfichage.

3. Module de communication suivant l'une des revendications 1 ou 2,
dans lequel les broches de centrage ont chacune une tête conique.

4. Module de communication suivant l'une des revendications 1 à 3,
dans lequel les broches de centrage comprennent des éléments d'encliquetage et peuvent être encliquetées dans les logements correspondants du module de base.

5. Module de communication suivant l'une des revendications 1 à 4,
dans lequel, sur la bague d'entraîneur, est formée une molette pour faire tourner la vis de fixation.

6. Module de communication suivant l'une des revendications 1 à 5,
dans lequel la bague d'entraîneur est solidaire en rotation du fût de la vis de fixation.

7. Module de communication suivant l'une des revendications 1 à 6,
dans lequel des extrémités axiales de l'évidement forment, le long du passage, respectivement, une butée pour la bague d'entraîneur.

8. Module de communication suivant l'une des revendications 1 à 7,
dans lequel le boîtier comprend au moins une unité d'émission et de réception, qui est conformée conformément à un protocole sélectionné de couche de transmission de bit et/ou de couche de sécurisation.
